# EUROPEAN PATENT APPLICATION

(11) **EP 4 525 591 A1**
(43) Date of publication of application: **19.03.2025**
(21) Application number: 24200659.1
(22) Date of filing: 16.09.2024
(51) Int. Cl.: H10K 59/122, H10K 59/131, H10K 59/35, H10K 59/80

(54) **DISPLAY PANEL AND METHOD OF MANUFACTURING SAME**

(30) Priority: 18.09.2023 KR 20230124056
(71) Applicant: Samsung Display Co., Ltd., Gyeonggi-Do (KR)
(72) Inventor: CHANG, Chongsup, Yongin-si (KR); LEE, Sang Jin, Yongin-si (KR); LEE, Changsuk, Yongin-si (KR); CHA, Myounggeun, Yongin-si (KR)
(74) Representative: Marks & Clerk LLP

(57) **Abstract**

A display panel includes: a base layer; a plurality of light emitting elements arranged on the base layer; a partition wall that is disposed between the light emitting elements and electrically connects electrodes of the light emitting elements; and a plurality of inorganic patterns arranged on the light emitting elements. A recessed part recessed in a direction to the base layer is defined in the partition wall, and each of the plurality of inorganic patterns is disposed on the partition wall and covers one side surface of the partition wall that defines the recessed part.

## Description

### BACKGROUND

Embodiments of the present disclosure described herein relate to a display panel and a method of manufacturing the same, and particularly, to a display panel having reliability and a method of manufacturing the same.

A display device is activated according to an electrical signal. The display device may include a display panel that displays an image. In the display panel, an organic light emitting display panel has low power consumption, high luminance, and high response speed.

Among the display panel, the organic light emitting display panel includes an anode, a cathode, and a light emitting pattern. The light emitting pattern is separated for each light emitting area, and the cathode provides a common voltage to each light emitting area.

### SUMMARY

Embodiments of the present disclosure provide a display panel having reduced defects by preventing moisture from penetrating into a light emitting element, and a method of manufacturing the same.

According to an embodiment, a display panel includes: a base layer; a plurality of light emitting elements arranged on the base layer; a partition wall that is disposed between the light emitting elements and electrically connects electrodes of the light emitting elements; and a plurality of inorganic patterns arranged on the light emitting elements. A recessed part recessed in a direction to the base layer is defined in the partition wall, and each of the plurality of inorganic patterns is disposed on the partition wall and cover a first side surface of the partition wall that defines the recessed part.

The partition wall may include a first sub-partition wall and a second sub-partition wall spaced apart from each other with the recessed part therebetween.

The display panel may further include a dummy pattern disposed between the partition wall and the inorganic patterns.

The dummy pattern may include a first dummy pattern disposed on the first sub-partition wall and a second dummy pattern disposed on the second sub-partition wall.

The recessed part may include a first recessed portion and a second recessed portion spaced apart from each other.

The partition wall may further include a third sub-partition wall disposed between the first recessed portion and the second recessed portion.

The dummy pattern may not be disposed on the third sub-partition wall.

The display panel may further include a bridge electrode that electrically connects the first sub-partition wall and the second sub-partition wall.

The light emitting elements may further include a first electrode disposed on the base layer, and the bridge electrode and the first electrode may be disposed on the same layer.

The display panel may further include a pixel defining film, in which a light emitting opening is defined and which is disposed on the base layer. A portion of the first electrode is exposed through the light emitting opening. A first contact hole that electrically connects the first sub-partition wall and the bridge electrode and a second contact hole that electrically connect the second sub-partition wall and the bridge electrode may be defined in the pixel defining film.

Each of the light emitting elements may include a first electrode disposed on the base layer, a light emitting layer disposed on the first electrode, a second electrode disposed on the light emitting layer, and a pixel defining film, in which a light emitting opening is defined and which is disposed on the base layer. A portion of the first electrode is exposed through the light emitting opening. The second electrode may be electrically connected to the partition wall.

The partition wall may include: a first partition wall layer disposed on the pixel defining film; and a second partition wall layer disposed on the first partition wall layer; and a second side surface of the first partition wall layer near the light emitting opening may be further recessed in a direction away from the light emitting opening than a third side surface of the second partition wall layer near the light emitting opening.

The second electrode may be in direct contact with the first partition wall layer.

A depth of the recessed part may be smaller than a thickness of the partition wall.

An open area, through which a portion of the first side surface of the partition wall is exposed, may be defined between a bottom surface of the recessed part and the inorganic patterns.

According to an embodiment, a method of manufacturing a display panel includes: providing a preliminary display panel including a base layer, a first electrode disposed on the base layer, and a preliminary pixel defining film that is disposed on the base layer and covers the first electrode; forming a preliminary partition wall on the preliminary pixel defining film; patterning the preliminary partition wall to form a partition wall in which a recessed part recessed in a direction to the base layer is defined, and which has conductivity by patterning the preliminary partition wall; forming a light emitting layer on the first electrode; forming a second electrode on the light emitting layer and which is electrically connected to the partition wall; and forming an inorganic pattern on the second electrode and portions of the partition wall. The inorganic pattern is disposed on the partition wall and cover one side surface of the partition wall that defines the recessed part.

The partition wall may include a first sub-partition wall and a second sub-partition wall spaced apart from each other with the recessed part therebetween, the preliminary display panel may further include a bridge electrode that is disposed on the base layer and electrically connects the first sub-partition wall and the second sub-partition wall, and the bridge electrode may be formed in the same process as a process forming of the first electrode.

The method may further include forming a contact hole that electrically connects the preliminary partition wall and the bridge electrode in the preliminary pixel defining film before the forming of the preliminary partition wall.

The forming of the inorganic pattern may include forming an inorganic layer on the second electrode and the partition wall, and forming the inorganic pattern by patterning the inorganic layer such that the inorganic layer does not overlap at least a portion of the recessed part.

The method may further include forming an opening overlapping the first electrode. The opening and the recessed part may be formed simultaneously.

At least some of the above and other features of the invention are set out in the claims.

### BRIEF DESCRIPTION OF THE FIGURES

The above and other aspects and features of the present disclosure will become apparent by describing in detail embodiments thereof with reference to the accompanying drawings.
FIG. 1A is a perspective view of a display device according to an embodiment of the present disclosure.
FIG. 1B is an exploded perspective view of the display device according to an embodiment of the present disclosure.
FIG. 2 is a cross-sectional view of a display panel according to an embodiment of the present disclosure.
FIG. 3 is a plan view of the display panel according to an embodiment of the present disclosure.
FIG. 4 is an enlarged plan view of a portion of a display area of the display panel according to an embodiment of the present disclosure.
FIG. 5 is a cross-sectional view of the display panel along line I-I' of FIG. 3 according to an embodiment of the present disclosure.
FIG. 6A is a cross-sectional view of the display panel along line II-II' of FIG. 4 according to an embodiment of the present disclosure.
FIG. 6B is an enlarged view of area AA' illustrated in FIG. 6A.
FIG. 7 is an enlarged view of area AA' illustrated in FIG. 6A according to another embodiment.
FIG. 8 is an enlarged view of area AA' illustrated in FIG. 6A according to still another embodiment.
FIGS. 9A to 9K are cross-sectional views illustrating some of the operations of a method of manufacturing a display panel according to an embodiment of the present disclosure.

### DETAILED DESCRIPTION

Since the present disclosure is variously modified and has alternative forms, an embodiment thereof will be illustrated in the drawings and will be described herein in detail. However, it should be understood that the present disclosure is not limited to a specific disclosure and includes all changes, equivalents, and substitutes included in the scope of the present disclosure.

In the present specification, the expression that a first component (or an area, a layer, a part, a portion, etc.) is "disposed on", "connected with" or "coupled to" a second component means that the first component is directly disposed on/connected with/coupled to the second component or means that a third component is interposed therebetween.

The same reference numerals refer to the same components. Further, in the drawings, the thickness, the ratio, and the dimension of components are exaggerated for effective description of technical contents.

For example, "an element" has the same meaning as "at least one element," unless the context clearly indicates otherwise. "At least one" is not to be construed as limiting "a" or "an." "Or" means "and/or." The term "and/or" includes all combinations of one or more components that may be defined by associated configurations.

The terms "first", "second", etc. are used to describe various components, but the components should not be limited by the terms. The terms are only used to distinguish one component from another component. For example, without departing from the right scope of the present disclosure, a first component may be referred to as a second component, and similarly, the second component may be also referred to as the first component. Singular expressions include plural expressions unless clearly otherwise indicated in the context.

Further, the terms "under", "beneath", "on", "above", etc. are used to describe a relationship between components illustrated in the drawings. The terms have relative concepts and are described with reference to a direction indicated in the drawing.

Unless otherwise defined, all terms (including technical terms and scientific terms) used in the present specification have the same meaning as commonly understood by those skilled in the art to which the present disclosure belongs. Further, terms defined should be construed as having the same meanings as those in the context of the related art, and are explicitly defined therein unless the terms are interpreted in an ideal or excessive formal meaning.

It will be understood that the terms "include", "comprise", "have", etc. specify the presence of features, numbers, steps, operations, elements, or components, described in the specification, or a combination thereof, not precluding the presence or additional possibility of one or more other features, numbers, steps, operations, elements, or components or a combination thereof.

Hereinafter, an embodiment of the present disclosure will be described with reference to the accompanying drawings.

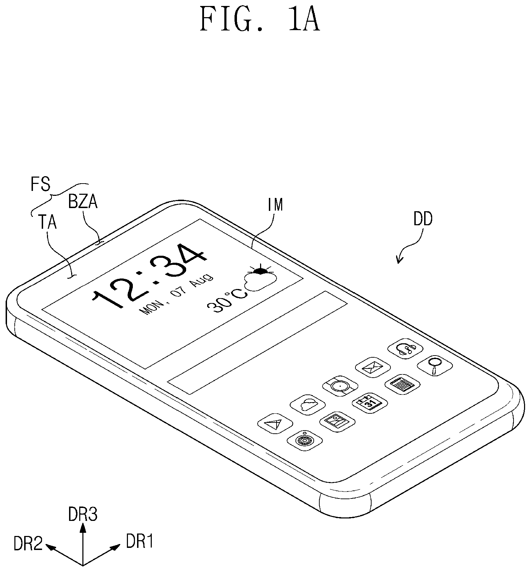

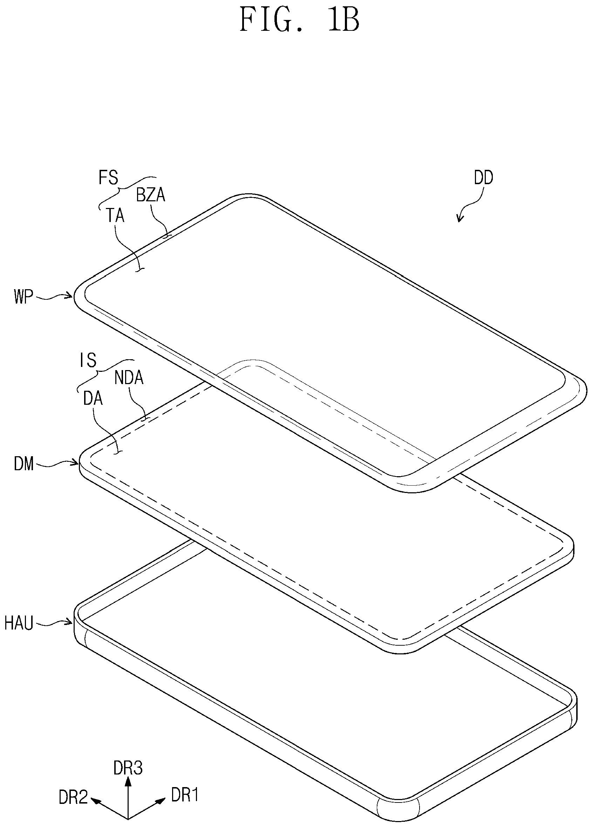

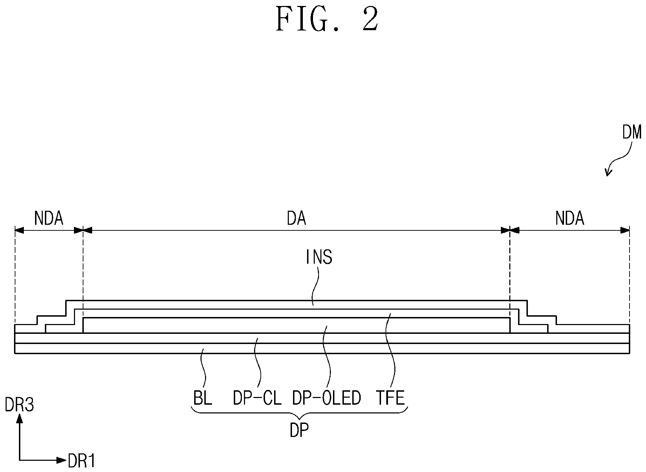

FIG. 1A is a perspective view of a display device according to an embodiment of the present disclosure. FIG. 1B is an exploded perspective view of the display device according to an embodiment of the present disclosure. FIG. 2 is a cross-sectional view of a display panel according to an embodiment of the present disclosure.

In an embodiment, a display device DD may be a large electronic device such as a television, a monitor, or an external billboard. Further, the display device DD may be a small or medium-sized electronic device such as a personal computer ("PC"), a laptop, a personal digital terminal, a vehicle navigation unit, a game console, a smart phone, a tablet PC, and a camera. These devices are merely presented as an embodiment and may be employed as other display devices as long as the display devices do not depart from the concept of the present disclosure. In an embodiment, the display device DD is exemplarily illustrated as a smart phone.

Referring to FIGS. 1A, 1B, and 2, the display device DD may display an image IM in a third direction DR3 on a display surface FS parallel to a first direction DR1 and a second direction DR2. The image IM may include a still image as well as a dynamic image. In FIG. 1, a watch window and icons are illustrated as an example of the image IM. The display surface FS on which the image IM is displayed may correspond to a front surface of the display device DD.

In an embodiment, a front surface (or an upper surface) and a rear surface (or a lower surface) of each member are defined with respect to a direction, in which the image IM is displayed. The front surface and the rear surface may face each other in the third direction DR3, and a normal direction of each of the front and rear surfaces may be parallel to the third direction DR3. Meanwhile, directions indicated by the first to third directions DR1, DR2, and DR3 are relative concepts and may be changed to other directions. In the specification, a phrase of "on a plane" may mean a state when viewed in the third direction DR3 (i.e., in a plan view).

As illustrated in FIG. 1B, the display device DD according to an embodiment may include a window WP, a display module DM, and a housing HAU. The window WP and the housing HAU may be coupled to each other to constitute an exterior of the display device DD.

The window WP may include an optically transparent insulating material. For example, the window WP may include a glass or plastic. A front surface of the window WP may define the display surface FS of the display device DD. The display surface FS may include a transmissive area TA and a bezel area BZA. The transmissive area TA may be an optically transparent area. For example, the transmissive area TA may be an area having a visible light transmittance of about 90% or more.

The bezel area BZA may be an area having a relatively lower light transmittance than a light transmittance of the transmissive area TA. The bezel area BZA may define a shape of the transmissive area TA. The bezel area BZA may be adjacent to the transmissive area TA and surround the transmissive area TA. Meanwhile, this is exemplarily illustrated, and in the window WP according to an embodiment of the present disclosure, the bezel area BZA may be omitted. The window WP may include at least one functional layer of a fingerprint preventing layer, a hard coating layer, and a reflection preventing layer, and is not limited to an embodiment.

The display module DM may be disposed under the window WP. The display module DM may be a component that substantially generates the image IM. The image IM generated by the display module DM is displayed on a display surface IS of the display module DM and is visually recognized by a user from the outside through the transmissive area TA.

The display surface IS of the display module DM may include a display area DA and a non-display area NDA. The display area DA may be an area that is activated according to an electric signal. The non-display area NDA is adjacent to the display area DA. The non-display area NDA may surround the display area DA. The non-display area NDA is an area covered by the bezel area BZA and may not be visually recognized from the outside.

As illustrated in FIG. 2, the display module DM according to an embodiment may include a display panel DP and an input sensor INS. Although not separately illustrated, the display device DD according to an embodiment of the present disclosure may further include a protective member disposed on a lower surface of the display panel DP or a reflection preventing member and/or a window member disposed on an upper surface of the input sensor INS.

The display panel DP may be a light emitting display panel, but the present disclosure is not particularly limited thereto. For example, the display panel DP may be an organic light emitting display panel or inorganic light emitting display panel. A light emitting pattern in the organic light emitting display panel includes an organic light emitting material. A light emitting pattern in the inorganic light emitting display panel includes a quantum dot, a quantum rod, or a micro light emitting diode ("LED"). Hereinafter, the display panel DP is described as the organic light emitting display panel.

The display panel DP may include a base layer BL, a circuit element layer DP-CL, a display element layer DP-OLED, and an encapsulation layer TFE which are arranged on the base layer BL. The input sensor INS may be directly disposed on the encapsulation layer TFE. In the specification, the wording "component A is directly disposed on component B" means that no adhesive layer is disposed between component A and component B.

The base layer BL may include at least one plastic film. The base layer BL is a flexible substrate and may include a plastic substrate, a glass substrate, a metal substrate, or an organic/inorganic composite material substrate. In the specification, it may be seen that the display area DA and the non-display area NDA are defined in the base layer BL, and in this case, it may be also seen that the components arranged on the base layer BL are arranged to overlap the display area DA or the non-display area NDA.

The circuit element layer DP-CL includes at least one insulating layer and a circuit element. The insulating layer includes at least one inorganic layer and at least one organic layer. The circuit element includes signal lines, a driving circuit of a pixel, and the like.

The display element layer DP-OLED includes a conductive partition wall and a light emitting element. The light emitting element may include an anode, a light emitting pattern, and a cathode, and the light emitting pattern may include at least a light emitting pattern.

The encapsulation layer TFE includes a plurality of thin films. Some thin films are arranged to improve optical efficiency, and some thin films are arranged to protect organic light emitting diodes.

The input sensor INS acquires coordinate information of an external input. The input sensor INS may have a multilayer structure. The input sensor INS may include a single-layered or multi-layered conductive layer. The input sensor INS may include a single-layered or multi-layered insulating layer. The input sensor INS may detect the external input, for example, in a capacitive manner. In the present disclosure, an operation method of the input sensor INS is not particularly limited, and in an embodiment of the present disclosure, the input sensor INS may detect the external input in an electromagnetic induction method or a pressure detection method. Meanwhile, in an embodiment of the present disclosure, the input sensor INS may be omitted.

As illustrated in FIG. 1B, the housing HAU may be coupled to the window WP. The housing HAU may be coupled to the window WP to provide a predetermined inner space. The display module DM may be accommodated in the inner space.

The housing HAU may include a material having a relatively high rigidity. For example, the housing HAU may include a plurality of frames and/or plates including a glass, a plastic, or a metal or made of a combination thereof. The housing HAU may stably protect components of the display device DD accommodated in the inner space from an external impact.

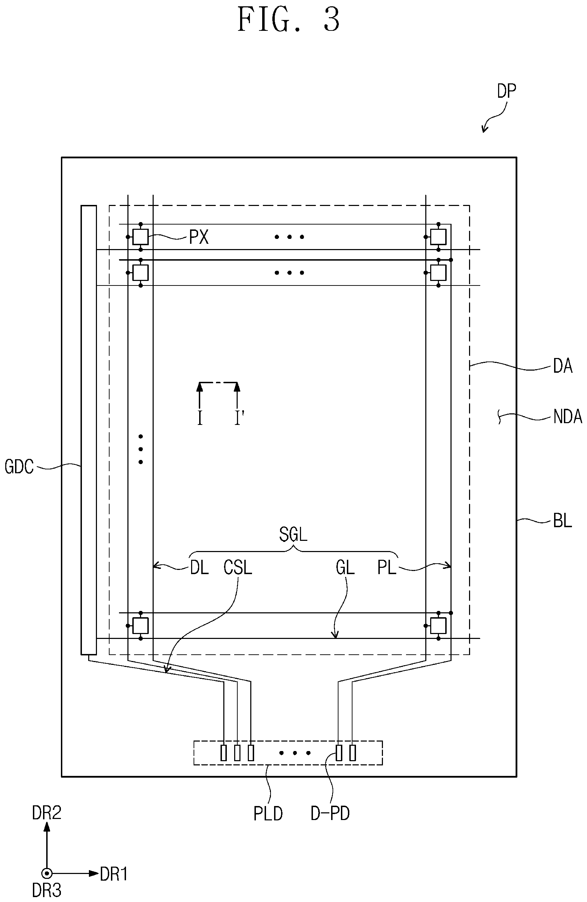

FIG. 3 is a plan view of the display panel according to an embodiment of the present disclosure.

Referring to FIG. 3, the display panel DP may include the base layer BL divided into the display area DA and the non-display area NDA which have been described with reference to FIG. 2.

The display panel DP may include pixels PX arranged in the display area DA and signal lines SGL electrically connected to the pixels PX. The display panel DP may include a driving circuit GDC and a pad part PLD arranged in the non-display area NDA.

The pixels PX may be arranged in the first direction DR1 and the second direction DR2. The pixels PX may include a plurality of pixel rows extending in the first direction DR1 and arranged in the second direction DR2 and a plurality of pixel columns extending in the second direction DR2 and arranged in the first direction DR1.

The signal lines SGL may include gate lines GL, data lines DL, a power line PL, and a control signal line CSL. Each of the gate lines GL may be connected to a corresponding pixel among the pixels PX, and each of the data lines DL may be connected to a corresponding pixel among the pixels PX. The power line PL may be electrically connected to the pixels PX. The control signal line CSL may be connected to the driving circuit GDC to provide control signals to the driving circuit GDC.

The driving circuit GDC may include a gate driving circuit. The gate driving circuit may generate gate signals and sequentially output the generated gate signal to the gate lines GL. The gate driving circuit may further output another control signal to a pixel driving circuit.

The pad part PLD may be a portion to which a flexible circuit board is connected. The pad part PLD may include pixel pads D-PD, and the pixel pads D-PD may be pads for connecting the flexible circuit board to the display panel DP. Each of the pixel pads D-PD may be connected to a corresponding signal line among the signal lines SGL. The pixel pads D-PD may be connected to the corresponding pixels PX through the signal lines SGL. Further, any one pixel pad among the pixel pads D-PD may be connected to the driving circuit GDC.

Further, the pad part PLD may further include input pads. The input pads may be pads for connecting the flexible circuit board to the input sensor INS (see FIG. 2). However, the present disclosure is not limited thereto, and the input pads may be arranged in the input sensor INS (see FIG. 2) and connected to the pixel pads D-PD and a separate circuit board in another embodiment. Alternatively, the input sensor INS (see FIG. 2) may be omitted and may not further include the input pads.

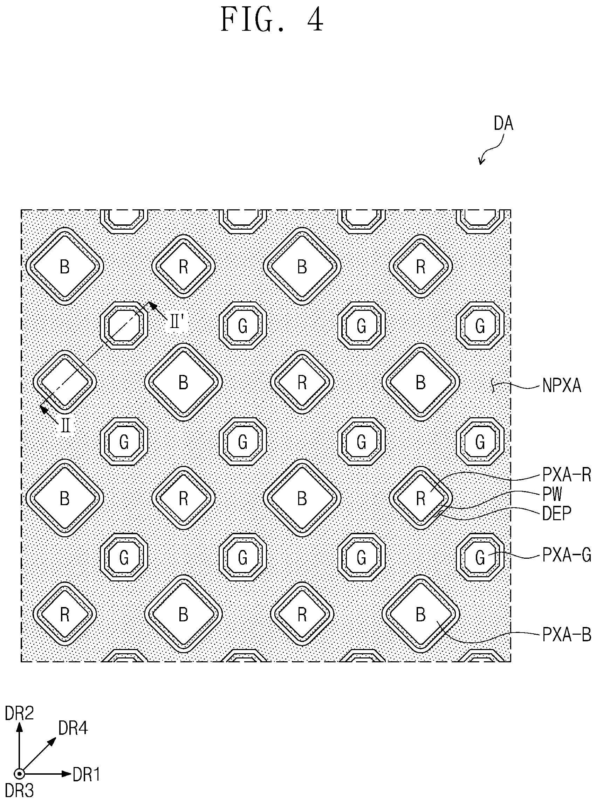

FIG. 4 is an enlarged plan view of a portion of a display area of the display panel according to an embodiment of the present disclosure. FIG. 4 illustrates a plan surface of the display module DM (see FIG. 2) when viewed from the display surface IS (see FIG. 2) of the display module DM (see FIG. 2) and illustrates arrangement of light emitting areas PXA-R, PXA-G, and PXA-B and a partition wall PW.

Referring to FIG. 4, the display area DA may include the first to third light emitting areas PXA-R, PXA-G, and PXA-B and a peripheral area NPXA that surrounds the first to third light emitting areas PXA-R, PXA-G, and PXA-B. The first to third light emitting areas PXA-R, PXA-G, and PXA-B may correspond to areas from which lights provided from the light emitting elements are emitted, respectively. The first to third light emitting areas PXA-R, PXA-G, and PXA-B may be classified according to a color of a light emitted toward the outside of the display module DM (see FIG. 2).

The first to third light emitting areas PXA-R, PXA-G, and PXA-B may provide first to third color lights having different colors, respectively. For example, the first color light may be a red light, the second color light may be a green light, and the third color light may be a blue color. However, examples of the first to third color light beams are not necessarily limited to the above example.

Each of the first to third light emitting areas PXA-R, PXA-G, and PXA-B may be defined as an area in which an upper surface of the anode is exposed by a light emitting opening, which will be described below. The peripheral area NPXA may set boundaries between the first to third light emitting areas PXA-R, PXA-G, and PXA-B and prevent color mixing between the first to third light emitting areas PXA-R, PXA-G, and PXA-B.

The first to third light emitting areas PXA-R, PXA-G, and PXA-B may be provided such that all of the numbers thereof are plural and may be repeatedly arranged in the display area DA in a specific arrangement form. For example, the first and third light emitting areas PXA-R and PXA-B may be alternately arranged in the first direction DR1 to constitute a "first group." The second light emitting areas PXA-G may arranged in the first direction DR1 to constitute a "second group." Each of the "first group" and the "second group" may be provided in plurality, and the "first groups" and the "second groups" may be alternately arranged in the second direction DR2.

One second light emitting area PXA-G may be spaced apart from one first light emitting area PXA-R or one third light emitting area PXA-B in a fourth direction DR4. The fourth direction DR4 may be defined as a direction between the first and second directions DR1 and DR2.

FIG. 4 exemplarily illustrates an arrangement form of the first to third light emitting areas PXA-R, PXA-G, and PXA-B, but the present disclosure is not limited thereto, and the first to third light emitting areas PXA-R, PXA-G, and PXA-B may be arranged in various forms. In an embodiment, as illustrated in FIG. 4, the first to third light emitting areas PXA-R, PXA-G, and PXA-B may have a PENTILE^{™} arrangement form. Alternatively, the first to third light emitting areas PXA-R, PXA-G, and PXA-B may have a stripe arrangement form or a diamond pixel^{™} arrangement form.

The first to third light emitting areas PXA-R, PXA-G, and PXA-B may have various shapes on a plane. For example, the first to third light emitting areas PXA-R, PXA-G, and PXA-B may have shapes such as a polygonal shape, a circular shape, or an elliptic shape. FIG. 4 exemplarily illustrates the first and third light emitting areas PXA-R and PXA-B having a quadrangular shape (or a diamond shape) and the second light emitting area PXA-G having an octagonal shape on a plane.

The first to third light emitting areas PXA-R, PXA-G, and PXA-B may have the same shape on a plane or may have at least partially different shapes. FIG. 4 exemplarily illustrates the first and third light emitting areas PXA-R and PXA-B having the same shape and the second light emitting area PXA-G having a shape different from the shapes of the first and third light emitting areas PXA-R and PXA-B on a plane.

At least some of the first to third light emitting areas PXA-R, PXA-G, and PXA-B may have different areas on a plane. In an embodiment, an area of the first light emitting area PXA-R, which emits a red light may be greater than an area of the second light emitting area PXA-G, which emits a green light and may be smaller than an area of the third light emitting area PXA-B, which emits a blue light. However, a size relationship between the areas of the first to third light emitting areas PXA-R, PXA-G, and PXA-B according to the color of the emitted light is not limited thereto and may be varied depending on a design of the display module DM (see FIG. 2). Further, the present disclosure is not limited thereto, and the first to third light emitting areas PXA-R, PXA-G, and PXA-B may also have the same area on a plane in another embodiment.

The shape, the area, the arrangement, and/or the like of the first to third light emitting areas PXA-R, PXA-G, and PXA-B of the display module DM (see FIG. 2) of the present disclosure may be variously designed according to the color of the emitted light or the size and configuration of the display module DM (see FIG. 2) and are not limited to an embodiment illustrated in FIG. 4.

According to an embodiment of the present disclosure, the partition wall PW may not overlap the first to third light emitting areas PXA-R, PXA-G, and PXA-B. The partition wall PW may have a shape that surrounds the first to third light emitting areas PXA-R, PXA-G, and PXA-B. In detail, the partition wall PW may have a closed-line shape that surrounds the first to third light emitting areas PXA-R, PXA-G, and PXA-B on a plane. A recessed part DEP may be formed in the partition wall PW. Detailed shapes of the partition wall PW and the recessed part DEP will be described below.

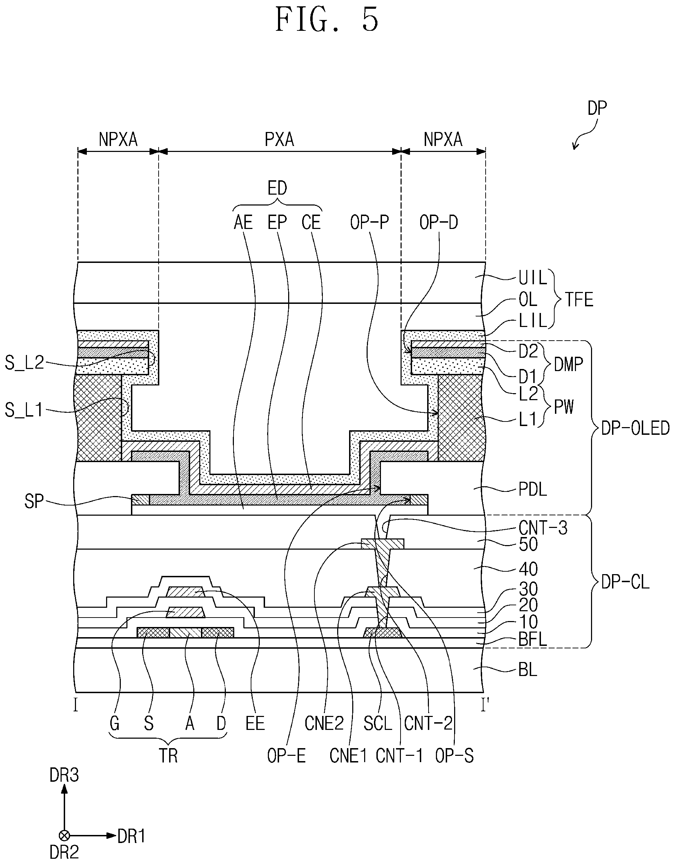

FIG. 5 is a cross-sectional view of the display panel along line I-I' of FIG. 3 according to an embodiment of the present disclosure. In description of FIG. 5, the description will be made with reference to FIG. 2, and descriptions for the same reference numerals will be omitted.

FIG. 5 enlargedly illustrates one light emitting area PXA in the display area DA (see FIG. 4), and the light emitting area PXA of FIG. 5 may correspond to one of the first to third light emitting areas PXA-R, PXA-G, and PXA-B of FIG. 4.

Referring to FIG. 5, the display panel DP may include the base layer BL, the circuit element layer DP-CL, the display element layer DP-OLED, and the encapsulation layer TFE.

The display panel DP may include a plurality of insulating layers, a semiconductor pattern, a conductive pattern, a signal line, and the like. The insulating layer, the semiconductor layer, and the conductive layer are formed by coating, deposition, or the like. Thereafter, the insulating layer, the semiconductor layer, and the conductive layer may be selectively patterned by photolithography and etching. In this manner, the semiconductor pattern, the conductive pattern, the signal line, and the like included in the circuit element layer DP-CL and the display element layer DP-OLED may be formed.

The circuit element layer DP-CL may be disposed on the base layer BL. The circuit element layer DP-CL may include a buffer layer BFL, a transistor TR, a signal transmitting area SCL, first to fifth insulating layers 10, 20, 30, 40, and 50, an electrode EE, and a plurality of connection electrodes CNE1 and CNE2.

The buffer layer BFL may be disposed on the base layer BL. The buffer layer BFL may improve a coupling force between the base layer BL and the semiconductor pattern. The buffer layer BFL may include a silicon oxide layer and a silicon nitride layer. The silicon oxide layer and the silicon nitride layer may be alternately laminated.

The semiconductor pattern may be disposed on the buffer layer BFL. The semiconductor pattern may include polysilicon. However, the present disclosure is not limited thereto, and the semiconductor pattern may include amorphous silicon or metal oxide. FIG. 5 exemplarily illustrates a portion of the semiconductor pattern, and the semiconductor patterns may be further arranged in the plurality of light emitting areas PXA-R, PXA-G, and PXA-B (see FIG. 4). The semiconductor pattern may be arranged in a specific rule across the plurality of light emitting areas PXA-R, PXA-G, and PXA-B. The semiconductor pattern may have a different electrical property depending on whether or not the semiconductor pattern is doped. The semiconductor pattern may include a first area having a high doping concentration and a second area having a low doping concentration. The first area may be doped with an N-type dopant or a P-type dopant. A P-type transistor may include the first area doped with the P-type dopant.

A conductivity of the first area is greater than a conductivity of the second area, and the first area may substantially serve as an electrode or a signal line. The second area may substantially correspond to an active (or a channel) of a transistor. In other words, a portion of the semiconductor pattern may be the active of the transistor, another portion of the semiconductor pattern may be a source or a drain of the transistor, and still another portion of the semiconductor pattern may be a conductive area.

A source "S," an active "A," and a drain "D" of the transistor TR may be formed from the semiconductor pattern. FIG. 5 illustrates a portion of the signal transmitting area SCL formed from the semiconductor pattern. Although not separately illustrated, the signal transmitting area SCL may be connected to the drain D of the transistor TR on a plane.

The first to fifth insulating layers 10, 20, 30, 40, and 50 may be arranged on the buffer layer BFL. The first to fifth insulating layers 10, 20, 30, 40, and 50 may be inorganic layers or organic layers.

The first insulating layer 10 may be disposed on the buffer layer BFL. The first insulating layer 10 may cover the source "S," the active "A," and the drain "D" of the transistor TR disposed on the buffer layer BFL, and the signal transmitting area SCL. A gate "G" of the transistor TR may be disposed on the first insulating layer 10. The second insulating layer 20 may be disposed on the first insulating layer 10 to cover the gate "G." The electrode EE may be disposed on the second insulating layer 20. The third insulating layer 30 may be disposed on the second insulating layer 20 to cover the electrode EE.

The first connection electrode CNE1 may be disposed on the third insulating layer 30. The first connection electrode CNE1 may be connected to the signal transmitting area SCL through a contact hole CNT-1 passing through the first to third insulating layers 10, 20, and 30. The fourth insulating layer 40 may be disposed on the third insulating layer 30 to cover the first connection electrode CNE1. The fourth insulating layer 40 may be an organic layer.

The second connection electrode CNE2 may be disposed on the fourth insulating layer 40. The second connection electrode CNE2 may be connected to the first connection electrode CNE1 through a contact hole CNT-2 passing through the fourth insulating layer 40. The fifth insulating layer 50 may be disposed on the fourth insulating layer 40 to cover the second connection electrode CNE2. The fifth insulating layer 50 may be an organic layer.

The display element layer DP-OLED may be disposed on the circuit element layer DP-CL. The display element layer DP-OLED may include a light emitting element ED, a sacrificial pattern SP, a pixel defining film PDL, the partition wall PW, and dummy patterns DMP.

The light emitting element ED may include an anode AE (or a first electrode), a light emitting pattern EP, and a cathode CE (or a second electrode).

The anode AE may be disposed on the fifth insulating layer 50 of the circuit element layer DP-CL. The anode AE may be a transmissive electrode, a semi-transmissive electrode, or a reflective electrode. The anode AE may be connected to the second connection electrode CNE2 through a connection contact hole CNT-3 defined through the fifth insulating layer 50. Thus, the anode AE may be electrically connected to the signal transmitting area SCL through the first and second connection electrodes CNE1 and CNE2 and thus electrically connected to the corresponding circuit element. The anode AE may include a single-layer structure or a multi-layer structure. The anode AE may include a plurality of layers including ITO and Ag. For example, the anode AE may include a layer including the ITO (hereinafter, referred to as a lower ITO layer), a layer disposed on the lower ITO layer and including Ag (hereinafter, referred to as an Ag layer), and a layer disposed on the Ag layer and including the ITO (hereinafter, referred to as an upper ITO layer).

The pixel defining film PDL may be disposed on the fifth insulating layer 50 of the circuit element layer DP-CL. A light emitting opening OP-E may be defined by the pixel defining film PDL. The light emitting opening OP-E may correspond the anode AE, and the pixel defining film PDL may expose at least a portion of the anode AE through the light emitting opening OP-E.

The sacrificial pattern SP may be disposed between the anode AE and the pixel defining film PDL. A sacrificial opening OP-S through which a portion of an upper surface of the anode AE is exposed may be defined in the sacrificial pattern SP. The sacrificial opening OP-S may overlap the light emitting opening OP-E in a plan view.

According to an embodiment, the upper surface of the anode AE may be spaced apart from the pixel defining film PDL in a cross section with the sacrificial pattern SP interposed therebetween, and accordingly, damage to the anode AE may be prevented in a process of forming the light emitting opening OP-E.

On a plane, a size of the light emitting opening OP-E may be smaller than a size of the sacrificial opening OP-S. That is, an inner surface of the pixel defining film PDL defining the light emitting opening OP-E may be closer to a center of the anode AE than an inner surface of the sacrificial pattern SP defining the sacrificial opening OP-S. However, the present disclosure is not limited thereto, and the inner surface of the sacrificial pattern SP defining the sacrificial opening OP-S may be substantially aligned with the inner surface of the pixel defining film PDL defining the light emitting opening OP-E in another embodiment. In this case, the light emitting area PXA may be regarded as an area of the anode AE exposed from the corresponding sacrificial opening OP-S.

The pixel defining film PDL may include an inorganic insulating material. For example, the pixel defining film PDL may include a silicon nitride (SiNₓ). The pixel defining film PDL may be disposed between the anode AE and the partition wall PW and block electrical connection between the anode AE and the partition wall PW.

The light emitting pattern EP may be disposed on the anode AE. The light emitting pattern EP may include a light emitting pattern including a light emitting material. The light emitting pattern EP may further include a hole injection layer and a hole transport layer arranged between the anode AE and the light emitting pattern and may further include an electron transport layer and an electron injection layer arranged on the light emitting pattern. The light emitting pattern EP may be referred to an "organic layer" or an "intermediate layer."

The light emitting pattern EP may be patterned by a tip portion defined by the partition wall PW. The light emitting pattern EP may be disposed inside the sacrificial opening OP-S, the light emitting opening OP-E, and a partition wall opening OP-P. The light emitting pattern EP may cover a portion of an upper surface of the pixel defining film PDL exposed from the partition wall opening OP-P.

The cathode CE may be disposed on the light emitting pattern EP. The cathode CE may be patterned by the tip portion defined by the partition wall PW. At least a portion of the cathode CE may be disposed on a side surface of the partition wall PW defining the partition wall opening OP-P.

The cathode CE may be conductive. The cathode CE may be formed of various materials such as a metal, a transparent conductive oxide ("TCO"), and a conductive polymer material as long as the materials may be conductive. For example, the cathode CE may include silver (Ag), magnesium (Mg), lead (Pb), copper (Cu), or compounds thereof.

The partition wall PW may be disposed on the pixel defining film PDL. The partition wall opening OP-P may be defined in the partition wall PW. The partition wall opening OP-P may correspond to (or overlap) the light emitting opening OP-E in a plan view and expose at least a portion of the cathode CE.

The partition wall PW may have an undercut shape on a cross section (i.e., in a cross-sectional view). The partition wall PW may include a plurality of layers that are sequentially laminated, and at least one layer of the plurality of layers may be recessed in a direction parallel to the first direction DR1 as compared to the other layers. Accordingly, the partition wall PW may include the tip portion.

The partition wall PW may include a first partition wall layer L1 and a second partition wall layer L2. The first partition wall layer L1 may be disposed on the pixel defining film PDL, and the second partition wall layer L2 may be disposed on the first partition wall layer L1. A thickness of the first partition wall layer L1 may be greater than a thickness of the second partition wall layer L2, but the present disclosure is not limited thereto. The cathode CE may be in contact with a side surface of the first partition wall layer L1 in another embodiment.

On a cross section (i.e., in a cross-sectional view), a side surface S_L2 of the second partition wall layer L2 may be closer to the center of the anode AE than a side surface S_L1 of the first partition wall layer L1 in a plan view. That is, the side surface S_L1 of the first partition wall layer L1 may be further recessed in a direction away from the center of the anode AE than the side surface S_L2 of the second partition wall layer L2. The first partition wall layer L1 may be further recessed with respect to the light emitting area PXA than the second partition wall layer L2. The first partition wall layer L1 may be formed to be undercut with respect to the second partition wall layer L2. A portion of the second partition wall layer L2, which protrudes from the first partition wall layer L1 toward the light emitting area PXA, may be defined as the tip portion inside the partition wall PW.

The first partition wall layer L1 and the second partition wall layer L2 may include a conductive material. For example, the conductive material may include a metal, a TCO, or a combination thereof. For example, the metal includes gold (Au), silver (Ag), aluminium (Al), magnesium (Mg), lithium (Li), molybdenum (Mo), titanium (Ti), copper (Cu), or alloys thereof. The TCO may include an indium tin oxide ("ITO"), an indium zinc oxide ("IZO"), a zinc oxide, an indium oxide, an indium gallium oxide, an indium gallium zinc oxide ("IGZO") or an aluminium zinc oxide.

FIG. 5 exemplarily illustrates that each of the side surface S_L1 of the first partition wall layer L1 and the side surface S_L2 of the second partition wall layer L2 is perpendicular to the upper surface of the pixel defining film PDL, but the present disclosure is not limited thereto. For another example, the partition wall PW may have a tapered shape or a reverse tapered shape. The partition wall PW may receive a bias voltage (or a cathode voltage). The cathode CE may be electrically connected to the first partition wall layer L1 and receive the bias voltage.

The dummy patterns DMP may be disposed on the partition wall PW. The dummy patterns DMP may include a first dummy layer D1 and a second dummy layer D2. The first and second dummy layers D1 and D2 may be sequentially laminated on an upper surface of the second partition wall layer L2 of the partition wall PW in the third direction DR3.

The first dummy layer D1 may include an organic material. For example, the first dummy layer D1 may include the same material as a material of the light emitting pattern EP. The first dummy layer D1 may be simultaneously formed through one process together with the light emitting pattern EP and formed separately from the light emitting pattern EP by the undercut shape of the partition wall PW.

The second dummy layer D2 may include a conductive material. For example, the second dummy layer D2 may include the same material as a material of the cathode CE. The second dummy layer D2 may be simultaneously formed through one process together with the cathode CE and formed separately from the cathode CE by the undercut shape of the partition wall PW.

A dummy opening OP-D may be defined in the dummy patterns DMP. The dummy opening OP-D may correspond to the light emitting opening OP-E. On a plane, each of the first and second dummy layers D1 and D2 may have a closed-line shape that surrounds the light emitting area PXA.

FIG. 5 exemplarily illustrates that inner surfaces of the first and second dummy layers D1 and D2 are aligned with the side surface S_L2 of the second partition wall layer L2, but the present disclosure is not limited thereto, and the first and second dummy layers D1 and D2 may cover the side surface S_L2 of the second partition wall layer L2 in another embodiment.

The encapsulation layer TFE may be disposed on the display element layer DP-OLED. The encapsulation layer TFE may include a lower inorganic pattern (or an inorganic pattern) LIL, an organic film OL, and an upper inorganic film UIL.

The lower inorganic pattern LIL may be disposed to correspond to the light emitting element ED and the partition wall PW. For example, a first portion of the lower inorganic pattern LIL may be disposed on the light emitting element ED, and a second portion of the lower inorganic pattern LIL may be disposed on the partition wall PW (the second partition wall layer L2). A portion of the lower inorganic pattern LIL may be disposed on the cathode CE to cover the light emitting element ED. Although not illustrated, the lower inorganic pattern LIL disposed on the partition wall PW may extend on the partition wall PW and cover one side surface of the partition wall PW that defines the recessed part DEP (see FIG. 4) formed in the partition wall PW. A detailed description therefor will be described below.

The organic film OL may cover the lower inorganic pattern LIL and provide a flat upper surface. The upper inorganic film UIL may be disposed on the organic film OL.

The lower inorganic pattern LIL and the upper inorganic film UIL may protect the display element layer DP-OLED from moisture/oxygen, and the organic film OL may protect the display element layer DP-OLED from foreign substances such as dust particles.

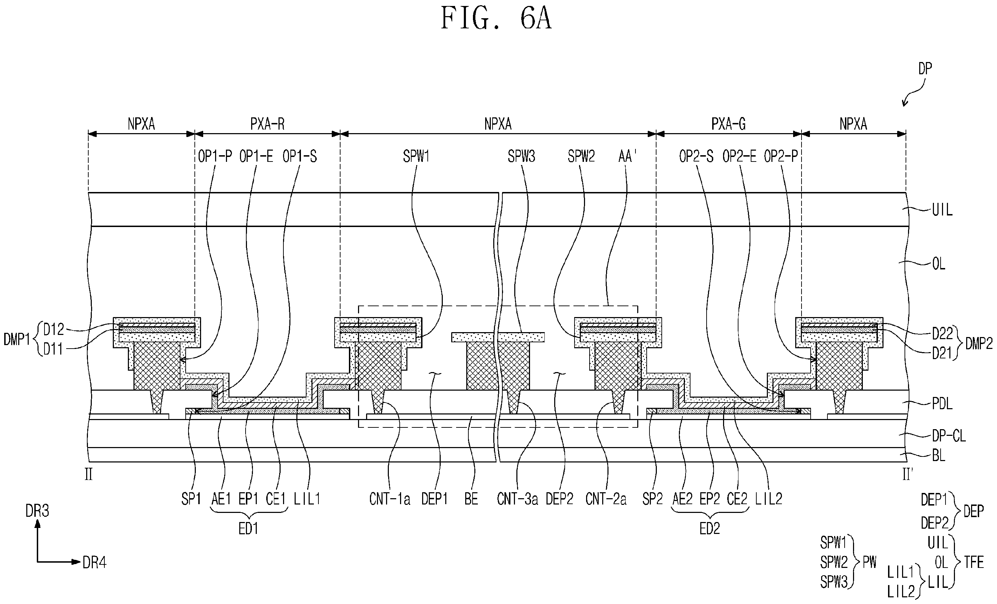

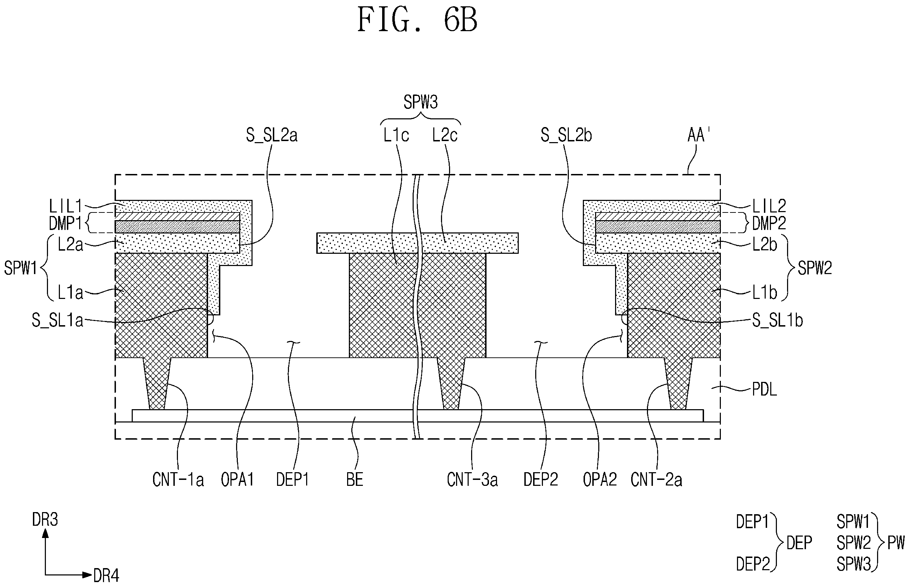

FIG. 6A is a cross-sectional view of the display panel along line II-II' of FIG. 4 according to an embodiment of the present disclosure. FIG. 6B is an enlarged view of area AA' illustrated in FIG. 6A.

FIG. 6A is an enlarged view of one first light emitting area PXA-R and one second light emitting area PXA-G, and the description of the light emitting area PXA in FIG. 5 may be equally applied to each of the first and second light emitting areas PXA-R and PXA-G. Further, although not illustrated, the description of the third light emitting area PXA-B illustrated in FIG. 4 may be equally applied to the description as the description of the first light emitting area PXA-R and the one second light emitting area PXA-G illustrated in FIG. 6A.

Referring to FIG. 6A, the display panel DP according to an embodiment may include the base layer BL, the circuit element layer DP-CL, the display element layer DP-OLED (see FIG. 5), and the encapsulation layer TFE. The display element layer DP-OLED may include light emitting elements ED1 and ED2, sacrificial patterns SP1 and SP2, the pixel defining film PDL, the partition wall PW, and dummy patterns DMP1 and DMP2. FIG. 6A simply illustrates the circuit element layer DP-CL, and the description of the circuit element layer DP-CL is duplicated with the description of FIG. 5 and thus will be omitted.

The light emitting elements ED1 and ED2 may include the first light emitting element ED1 and the second light emitting element ED2.

The first light emitting element ED1 may include a first anode AE1, a first light emitting pattern EP1, and a first cathode CE1, and the second light emitting element ED2 may include a second anode AE2, a second light emitting pattern EP2, and a second cathode CE2. The first and second anodes AE1 and AE2 may be provided as a plurality of patterns. In an embodiment, the first light emitting pattern EP1 may provide a red light, and the second light emitting pattern EP2 may provide a green light.

In an embodiment, first and second light emitting openings OP1-E and OP2-E may be defined in the pixel defining film PDL. The first light emitting opening OP1-E may expose at least a portion of the first anode AE1. The first light emitting area PXA-R may be defined as an area of an upper surface of the first anode AE1, which is exposed by the first light emitting opening OP1-E. The second light emitting opening OP2-E may expose at least a portion of the second anode AE2. The second light emitting area PXA-G may be defined as an area of an upper surface of the second anode AE2, which is exposed by the second light emitting opening OP2-E.

In an embodiment, the sacrificial patterns SP1 and SP2 may include the first sacrificial pattern SP1 and the second sacrificial pattern SP2. The first sacrificial pattern SP1 and the second sacrificial pattern SP2 may be arranged on upper surfaces of the first and second anodes AE1 and AE2, respectively. First and second sacrificial openings OP1-S and OP2-S corresponding to the first and second light emitting openings OP1-E and OP2-E may be defined in the first and second sacrificial patterns SP1 and SP2, respectively.

The first light emitting pattern EP1 and the first cathode CE1 may be arranged inside the first light emitting opening OP1-E and the first partition wall opening OP1-P, and the second light emitting pattern EP2 and the second cathode CE2 may be arranged inside the second light emitting opening OP2-E and the second partition wall opening OP2-P.

The partition wall PW may be disposed on the pixel defining film PDL. The partition wall PW may be the same as the partition wall PW described in FIG. 5. According to the present disclosure, the light emitting patterns EP1 and EP2 may be patterned and deposited in units of pixels by the tip portion defined in the partition wall PW. That is, the light emitting patterns EP1 and EP2 may be commonly formed using an open mask but may be easily divided by the partition wall PW in units of pixels.

The first and second cathodes CE1 and CE2 may be in contact with side surfaces of the partition wall PW. In an embodiment of the present disclosure, the first and second cathodes CE1 and CE2 may be physically separated by the partition wall PW forming the tip portion, may be in contact with the partition wall PW inside the partition wall openings OP1-P and OP2-P, may be electrically connected to each other, and thus may receive a common voltage. That is, electrodes (i.e., cathodes) of the light emitting elements ED1 and ED2 spaced apart from each other may be electrically connected to each other through the partition wall PW and thus receive the common voltage. As a result, a common cathode voltage may be uniformly provided to the light emitting elements ED1 and ED2.

When the light emitting patterns EP1 and EP2 are patterned using a fine metal mask ("FMM"), a support spacer protruding from the partition wall PW to support the FMM should be provided. Further, since the FMM is spaced apart from a base surface, on which the patterning is performed, by a height of the partition wall PW and the spacer, implementation in a high resolution may be limited. Further, as the FMM is in contact with the spacer, after the patterning process for the light emitting patterns EP1 and EP2, foreign substances may remain on the spacer, and the spacer may be damaged due to stamping of the FMM. Accordingly, a defective display panel may be formed.

According to an embodiment of the present disclosure, the display panel DP includes the partition wall PW, and thus the light emitting elements ED1 and ED2 may be physically and easily separated from each other. Accordingly, current leakage or driving errors between the adjacent light emitting areas PXA-R and PXA-G may be prevented, and independent driving for each of the light emitting elements ED1 and ED2 may be performed.

In particular, the light emitting patterns EP1 and EP2 are patterned with no mask in contact with an internal component inside the display area DA (see FIG. 2), and thus the display panel DP having improved process reliability due to a reduced defect rate may be provided. As the patterning may be performed even when a separate support spacer protruding from the partition wall PW is not provided, areas of the light emitting areas PXA-R and PXA-G may be miniaturized, and thus the display panel DP that easily implements a high resolution may be provided.

Further, in manufacturing the large-area display panel DP, the display panel DP may be provided in which process cost may be reduced as production of a large-area mask is omitted and process reliability may be improved as the display panel DP is not affected by defects that may occur in the large-area mask.

The recessed part DEP is formed in the partition wall PW. The recessed part DEP is recessed in a direction perpendicular to an upper surface of the base layer BL (or toward the base layer BL). In detail, the recessed part DEP is recessed in an opposite direction to the third direction DR3. The recessed part DEP may be formed to completely pass through the partition wall PW. That is, the upper surface of the pixel defining film PDL may be exposed by the recessed part DEP, and hereinafter, a bottom surface of the recessed part DEP may indicate the upper surface of the pixel defining film PDL.

The recessed part DEP may include a first recessed portion DEP1 and a second recessed portion DEP2 spaced apart from the first recessed portion DEP1 in the fourth direction DR4. The partition wall PW may be divided into first to third sub-partition walls SPW1, SPW2, and SPW3 by the first recessed portion DEP1 and the second recessed portion DEP2. As an example of the present disclosure, the first sub-partition wall SPW1 is provided in a closed-loop form to surround the first light emitting area PXA-R, and the second sub-partition wall SPW2 is provided in a closed-loop form to surround the second light emitting area PXA-G. The third sub-partition wall SPW3 is disposed between the first and second sub-partition walls SPW1 and SPW2. The first recessed portion DEP1 is provided between the first sub-partition wall SPW1 and the third sub-partition wall SPW3, and the second recessed portion DEP2 is provided between the second sub-partition wall SPW2 and the third sub-partition wall SPW3. The third sub-partition wall SPW3 may be disposed between the first recessed portion DEP1 and the second recessed portion DEP2. The present disclosure is not limited to the above description, and the recessed part DEP may include three or more recessed portions.

The display panel DP of the present disclosure may further include a bridge electrode BE disposed on the circuit element layer DP-CL. The bridge electrode BE may be covered by the pixel defining film PDL. As an example of the present disclosure, the bridge electrode BE is disposed on the same layer as the layer of the first and second anodes AE1 and AE2. First to third contact holes CNT-1a, CNT-2a, and CNT-3a that expose the bridge electrode BE are provided in the pixel defining film PDL. The bridge electrode BE may be in contact with the first to third sub-partition walls SPW1, SPW2, and SPW3 by the first to third contact holes CNT-1a, CNT-2a, and CNT-3a formed in the pixel defining film PDL. Thus, the bridge electrode BE may electrically connect the first to third sub-partition walls SPW1, SPW2, and SPW3 spaced apart from each other.

The dummy pattern DMP1 and DMP2 may include the first dummy pattern DMP1 and the second dummy pattern DMP2. The first dummy pattern DMP1 may be disposed on the first sub-partition wall SPW1, and the second dummy pattern DMP2 may be disposed on the second sub-partition wall SPW2. The dummy pattern DMP may not be disposed on the third sub-partition wall SPW3.

The first dummy pattern DMP1 may include a (1-1)^{th} dummy layer D11 and a (1-2)^{th} dummy layer D12 disposed on the (1-1)^{th} dummy layer D11. The (1-1)^{th} dummy layer D11 and the (1-2)^{th} dummy layer D12 may be arranged on the first sub-partition wall SPW1. The second dummy pattern DMP2 may include a (2-1)^{th} dummy layer D21 and a (2-2)^{th} dummy layer D22 disposed on the (2-1)^{th} dummy layer D21. The (2-1)^{th} dummy layer D21 and the (2-2)^{th} dummy layer D22 may be arranged on the second sub-partition wall SPW2. The first dummy pattern DMP1 and the second dummy pattern DMP2 may surround the first and second light emitting areas PXA-R and PXA-G on a plane.

The encapsulation layer TFE may include lower inorganic patterns (or inorganic patterns) LIL1 and LIL2, the organic film OL, and the upper inorganic film UIL.

In an embodiment of the present disclosure, the lower inorganic patterns LIL1 and LIL2 may include the first lower inorganic pattern LIL1 and the second lower inorganic pattern LIL2. The first lower inorganic pattern LIL1 and the second lower inorganic pattern LIL2 may be provided in a pattern form in which the first lower inorganic pattern LIL1 and the second lower inorganic pattern LIL2 are spaced apart from each other.

The first lower inorganic pattern LIL1 and the second lower inorganic pattern LIL2 may cover the first and second light emitting elements ED1 and ED2, respectively. In detail, the first lower inorganic pattern LIL1 and the second lower inorganic pattern LIL2 may be arranged on the first and second cathodes CE1 and CE2 to cover the first and second cathodes CE1 and CE2, respectively.

According to an embodiment of the present disclosure, the first lower inorganic pattern LIL1 and the second lower inorganic pattern LIL2 may cover side surfaces of the partition wall PW. In detail, the first lower inorganic pattern LIL1 may cover one side surface of the first sub-partition wall SPW1 that defines the first recessed portion DEP1, and the second lower inorganic pattern LIL2 may cover one side surface of the second sub-partition wall SPW2 that defines the second recessed portion DEP2.

In this way, when the partition wall PW includes the recessed portions DEP1 and DEP2, a length from portions (i.e., first portions) of the lower inorganic patterns LIL1 and LIL2 that cover the light emitting elements ED1 and ED2 to the other portions (i.e., second portions) of the lower inorganic patterns LIL1 and LIL2 arranged on the partition wall PW may increase. When the length of the second portions of the lower inorganic patterns LIL1 and LIL2 increases, a moisture permeation path to the light emitting elements ED1 and ED2 may increase. As a result, the light emitting elements ED1 and ED2 having improved process reliability and reduced defects by preventing moisture from penetrating into the light emitting elements ED1 and ED2 may be provided.

Referring to FIG 6B, the partition wall PW may be divided into first to third sub-partition walls SPW1, SPW2, and SPW3 by the first recessed portion DEP1 and the second recessed portion DEP2. The first to third sub-partition walls SPW1, SPW2, and SPW3 may be electrically connected to each other by the bridge electrode BE disposed on the circuit element layer DP-CL.

The first contact hole CNT-1a may be formed in the pixel defining film PDL that overlaps the first sub-partition wall SPW1, the second contact hole CNT-2a may be formed in the pixel defining film PDL that overlaps the second sub-partition wall SPW2, and the third contact hole CNT-3a may be formed in the pixel defining film PDL that overlaps the third sub-partition wall SPW3 in a plan view. The first sub-partition wall SPW1 and the bridge electrode BE may be electrically connected to each other through the first contact hole CNT-1a, the second sub-partition wall SPW2 and the bridge electrode BE may be electrically connected to each other through the second contact hole CNT-2a, and the third sub-partition wall SPW3 and the bridge electrode BE may be electrically connected to each other through the third contact hole CNT-3a. As a result, the first to third sub-partition walls SPW1, SPW2, and SPW3 may be electrically connected to each other by the bridge electrode BE. According to an embodiment of the present disclosure, the third contact hole CNT-3a may be omitted. As a result, only the first sub-partition wall SPW1 and the second sub-partition wall SPW2 may be electrically connected to each other by the bridge electrode BE, and the third sub-partition wall SPW3 may not be electrically connected to the first sub-partition wall SPW1 and the second sub-partition wall SPW2. The bridge electrode BE may not be connected to the transistor TR illustrated in FIG. 5.

The first sub-partition wall SPW1 may include a first partition wall layer L1a and a second partition wall layer L2a, which are sequentially laminated. The first partition wall layer L1a and the second partition wall layer L2a may be the same as the first partition wall layer L1 and the second partition wall layer L2 of the partition wall PW illustrated in FIG. 5, respectively. The first partition wall layer L1a and the second partition wall layer L2a may include a first side surface S_SL1a and a second side surface S_SL2a, respectively, which define the first recessed portion DEP1. The first side surface S_SL1a of the first partition wall layer L1a may be further recessed in a direction away from a center of the first recessed portion DEP1 than the second side surface S_SL2a of the second partition wall layer L2a in a plan view. That is, the second partition wall layer L2a may form a tip portion that protrudes toward the center of the first recessed portion DEP1 with respect to the first partition wall layer L1a in a plan view.

The second sub-partition wall SPW2 may include a first partition wall layer L1b and a second partition wall layer L2b that are sequentially laminated. The first partition wall layer L1b and the second partition wall layer L2b may be the same as the first partition wall layer L1 and the second partition wall layer L2 of the partition wall PW illustrated in FIG. 5. The first partition wall layer L1b and the second partition wall layer L2b may include a first side surface S_SL1b and a second side surface S_SL2b that define the second recessed portion DEP2. The first side surface S_SL1b of the first partition wall layer L1b may be further recessed in a direction away from a center of the second recessed portion DEP2 than the second side surface S_SL2b of the second partition wall layer L2b in a plan view. That is, the second partition wall layer L2b may form a tip portion that protrudes toward the center of the second recessed portion DEP2 with respect to the first partition wall layer L1b.

The third sub-partition wall SPW3 may include a first partition wall layer Lie and a second partition wall layer L2c that are sequentially laminated. The first partition wall layer Lie and the second partition wall layer L2c of the third sub-partition wall SPW3 may be formed in the same manner as a manner forming the first partition wall layer L1a and the second partition wall layer L2a of the first sub-partition wall SPW1 and may include the same material as a material of the first partition wall layer L1a and the second partition wall layer L2a. Further, the first partition wall layer Lie and the second partition wall layer L2c of the third sub-partition wall SPW3 may be formed in the same manner as a manner forming the first partition wall layer L1b and the second partition wall layer L2b of the second sub-partition wall SPW2 and may include the same material as a material of the first partition wall layer L1b and the second partition wall layer L2b.

The first dummy pattern DMP1 may be disposed on the second partition wall layer L2a of the first sub-partition wall SPW1. The first dummy pattern DMP1 may include a metallic material. As the first dummy pattern DMP1 is formed on the second partition wall layer L2a, when moisture penetrates into the first light emitting element ED1 (see FIG. 6A), the moisture or the like generates an oxidation reaction with the metallic material, and thus the moisture may be prevented from penetrating into the first light emitting element ED1.

The second dummy pattern DMP2 may be disposed on the second partition wall layer L2b of the second sub-partition wall SPW2. The second dummy pattern DMP2 may include a metallic material. As the second dummy pattern DMP2 is formed on the second partition wall layer L2b, when moisture penetrates into the second light emitting element ED2 (see FIG. 6A), the moisture or the like generates an oxidation reaction with the metallic material, and thus the moisture may be prevented from penetrating into the second light emitting element ED2.

According to an embodiment of the present disclosure, a first open area OPA1, through which a portion of a side surface of the first sub-partition wall SPW1 is exposed, may be defined between a bottom surface of the first recessed portion DEP1 and the first lower inorganic pattern LIL1. In detail, a portion of the first side surface S_SL1a of the first partition wall layer L1a, which is adjacent to the bottom surface of the first recessed portion DEP1 may be exposed through the first open area OPA1. According to an embodiment of the present disclosure, a second open area OPA2, through which a portion of a side surface of the second sub-partition wall SPW2 is exposed, may be defined between a bottom surface of the second recessed portion DEP2 and the second lower inorganic pattern LIL2. In detail, a portion of the first side surface S_SL1b of the first partition wall layer L1b, which is adjacent to the bottom surface of the second recessed portion DEP2 may be exposed through the second open area OPA2. The first open area OPA1 and the second open area OPA2 are areas in which a dummy pattern is originally formed and may be formed by removing the dummy pattern in a process of the display panel DP (see FIG. 6A).

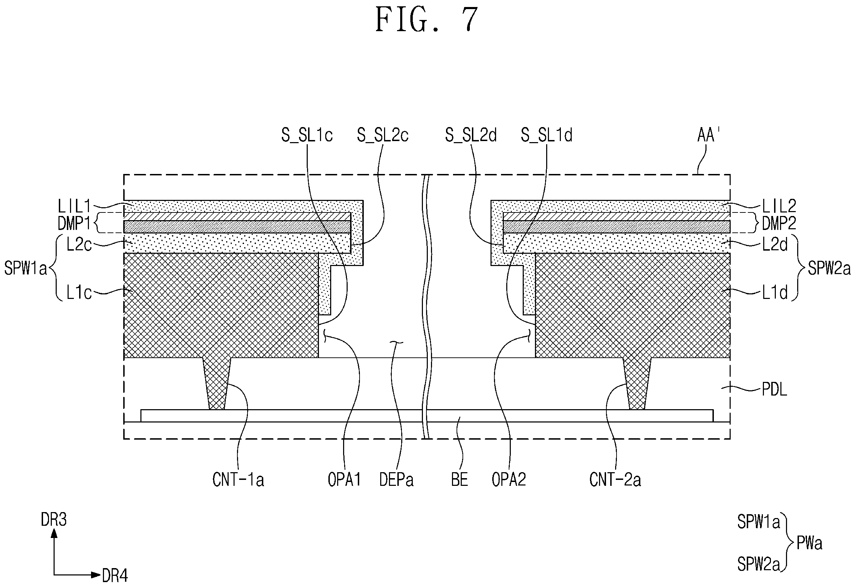

FIG. 7 is an enlarged view of area AA' illustrated in FIG. 6A according to another embodiment. Descriptions duplicated with the above description will be omitted.

Referring to FIG. 7, a recessed part DEPa may be formed in a partition wall PWa. According to an embodiment of the present disclosure, the single recessed part DEPa may be formed in the partition wall PWa. As the single recessed part DEPa is formed in the partition wall PWa, the partition wall PWa may include a first sub-partition wall SPW1a and a second sub-partition wall SPW2a. That is, the first sub-partition wall SPW1a and the second sub-partition wall SPW2a may be divided by the recessed part DEPa. As compared to the partition wall PW of FIG. 6B, the partition wall PWa according to an embodiment may not include the third sub-partition wall SPW3.

The first sub-partition wall SPW1a may include the first partition wall layer Lie and the second partition wall layer L2c that are sequentially laminated. The first partition wall layer L1c may include a first side surface S_SL1c, and the second partition wall layer L2c may include a second side surface S_SL2c. The second sub-partition wall SPW2a may include a first partition wall layer L1d and a second partition wall layer L2d that are sequentially laminated. The first partition wall layer L1d may include a first side surface S_SL1d, and the second partition wall layer L2d may include a second side surface S_SL2d. The first side surface S_SL1c of the first partition wall layer Lie and the second side surface S_SL2c of the second partition wall layer L2c may correspond to one side surface of the first sub-partition wall SPW1a that defines the recessed part DEPa, and the first side surface S_SL1D of the first partition wall layer L1d and the second side surface S_SL2d of the second partition wall layer L2d may correspond to one side surface of the second sub-partition wall SPW2a that defines the recessed part DEPa.

The first lower inorganic pattern LIL1 may cover one side surface of the first sub-partition wall SPW1a that defines the recessed part DEPa, and the second lower inorganic pattern LIL2 may cover one side surface of the second sub-partition wall SPW2a that defines the recessed part DEPa.

The recessed part DEPa may include a structure surrounding the light emitting elements ED1 and ED2 on a plane. That is, the recessed part DEPa may include an integrally-formed structure surrounding the light emitting elements ED1 and ED2. The recessed part DEPa may be disposed in the peripheral area NPXA (see FIG. 4).

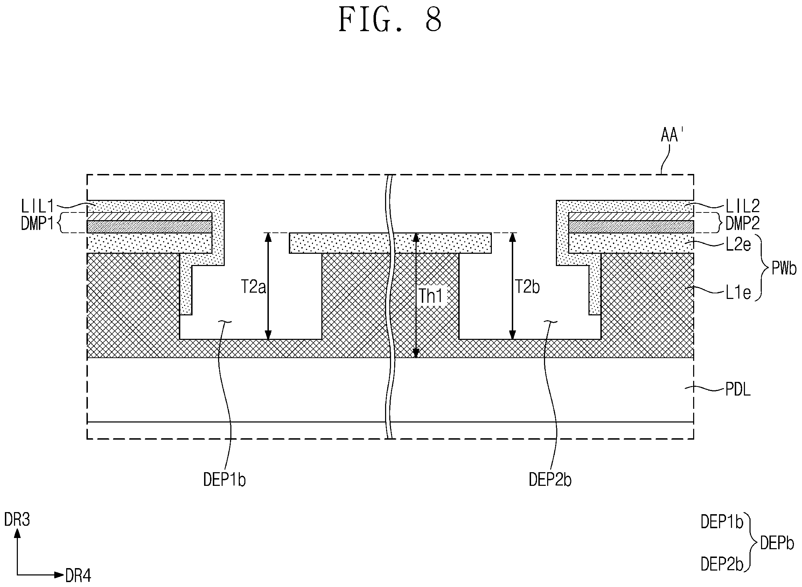

FIG. 8 is an enlarged view of area AA' illustrated in FIG. 6A according to still another embodiment.

Referring to FIG. 8, a first recessed portion DEPlb and a second recessed portion DEP2b may be defined in a partition wall PWb. According to an embodiment of the present disclosure, a thickness Thi of the partition wall PWb may be greater than each of a depth T2a of the first recessed portion DEPlb and a depth T2b of the second recessed portion DEP2b. In detail, the partition wall PWb may include a first partition wall layer Lie and a second partition wall layer L2e that are sequentially laminated. The sum of the thicknesses of the first partition wall layer Lie and the second partition wall layer L2e in the third direction DR3 may be greater than each of the depth T2a of the first recessed portion DEPlb and the depth T2b of the second recessed portion DEP2b. The depth T2a of the first recessed portion DEPlb and the depth T2b of the second recessed portion DEP2b may be the same. However, the present disclosure is not limited thereto, and the depth T2a of the first recessed portion DEPlb and the depth T2b of the second recessed portion DEP2b may be different from each other.

As the thickness Th1 of the partition wall PWb is greater than each of the depth T2a of the first recessed portion DEPlb and the depth T2b of the second recessed portion DEP2b, the partition wall PWb includes one first partition wall layer Lie but may include a plurality of second partition wall layers L2e divided by the recessed part. In this case, the bridge electrode BE illustrated in FIG. 6A may not be disposed. Further, the first and second cathodes CE1 and CE2 (see FIG. 6A) may be in contact with the partition wall PWb, may be electrically connected to each other, and thus may receive a common voltage.

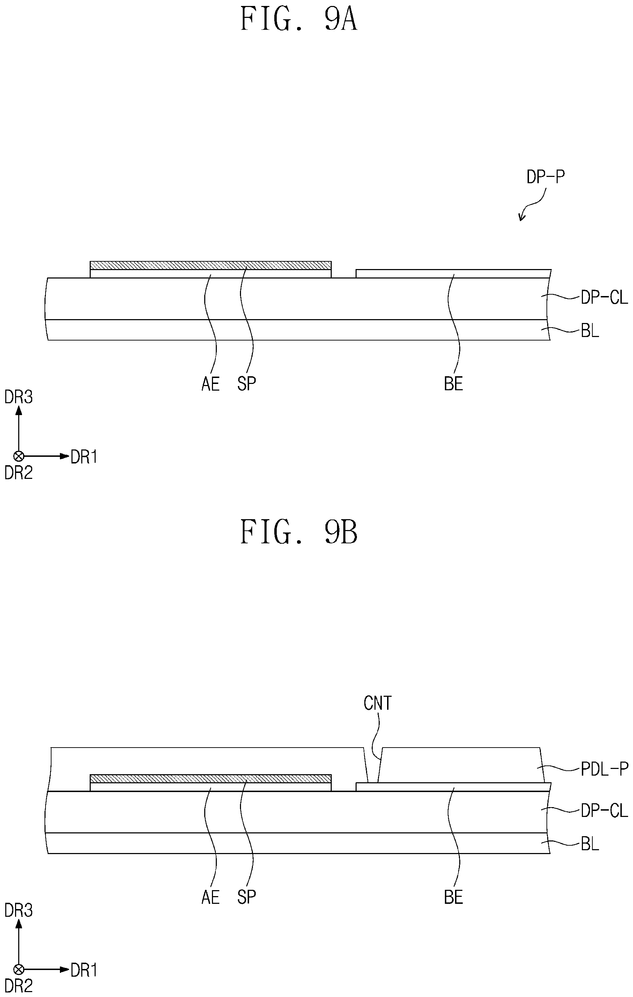

FIGS. 9A to 9K are cross-sectional views illustrating some of operations of a method of manufacturing a display panel according to an embodiment of the present disclosure. In description of the method of manufacturing a display panel with reference to FIGS. 9A to 9K, the same/similar reference numerals are used for the same/similar components described in FIGS. 1 to 8, and a duplicated description thereof that will be omitted.

Referring to FIG. 9A, the method of manufacturing a display panel according to an embodiment of the present disclosure includes an operation of providing a preliminary display panel DP-P. The preliminary display panel DP-P provided in an embodiment may include the base layer BL, the circuit element layer DP-CL, the anode AE, the sacrificial pattern SP, and the bridge electrode BE. In another embodiment, the preliminary display panel DP-P may further include a preliminary pixel defining film PDL-P as illustrated in FIG. 9B.

The circuit element layer DP-CL may be formed by a general method of manufacturing a circuit element, in which an insulating layer, a semiconductor layer, and a conductive layer are formed through a coating method or a deposition method, the insulating layer, the semiconductor layer, and the conductive layer are selectively patterned by a photolithography and etching process, and a semiconductor pattern, a conductive pattern, a signal line or the like are formed.

The anode AE and sacrificial pattern SP may be formed through the same patterning process. The bridge electrode BE may be formed through the same process as the anode AE. Although not illustrated, the anode AE and the bridge electrode BE may be separated through a patterning process on an integrally formed metal.

Referring to FIG. 9B, the preliminary pixel defining film PDL-P may be formed on the circuit element layer DP-CL. The preliminary pixel defining film PDL-P may cover all the anode AE, the bridge electrode BE, and the sacrificial pattern SP. A contact hole CNT, through which a portion of the bridge electrode BE is exposed, may be formed in the preliminary pixel defining film PDL-P.

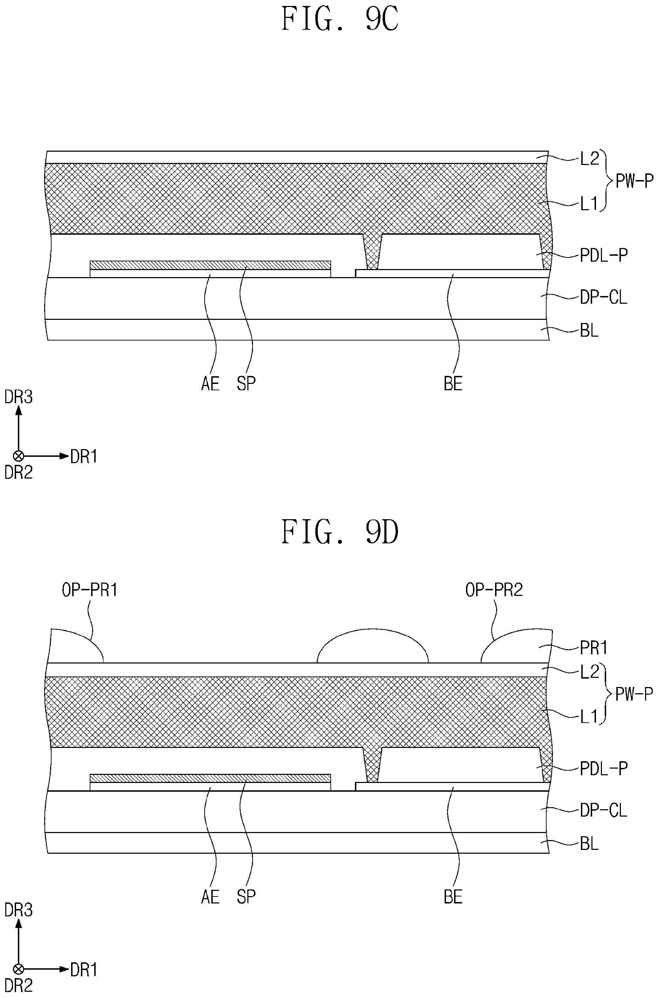

Thereafter, referring to FIG. 9C, a preliminary partition wall PW-P including the first partition wall layer L1 and the second partition wall layer L2 may be formed on the preliminary pixel defining film PDL-P. The operation of forming the preliminary partition wall PW-P may include an operation of forming the first partition wall layer L1 including a conductive material on the preliminary pixel defining film PDL-P and an operation of forming the second partition wall layer L2 including an inorganic material on the first partition wall layer L1. The second partition wall layer L2 may also include a conductive material.

The operation of forming the first partition wall layer L1 may be performed through a process of depositing a conductive material. In an embodiment of the present disclosure, the conductive material may include a metal. In detail, the first partition wall layer L1 may include aluminium (Al). For example, the operation of forming the first partition wall layer L1 may be performed through a sputtering deposition process.

The operation of forming the second partition wall layer L2 may be performed through a process of depositing an inorganic material. In an embodiment of the present disclosure, the second partition wall layer L2 may include at least one of silicon nitride (SiNₓ), silicon oxide (SiO₂), silicon oxy nitride (SiON), or aluminium oxide (Al₂O₃). The operation of forming the second partition wall layer L2 may be performed through a chemical vapor deposition ("CVD") process or an atomic layer deposition ("ALD") process.

Thereafter, referring to FIGS. 9C and 9D, an operation of forming a first photoresist layer PR1 on the preliminary partition wall PW-P may be performed. The first photoresist layer PR1 may be formed by forming a preliminary photoresist layer on the preliminary partition wall PW-P and then patterning the preliminary photoresist layer using a photo mask. Through the patterning process, a first photo opening OP-PR1 overlapping the anode AE and a second photo opening OP-PR2 overlapping the bridge electrode BE in a plan view may be formed in the first photoresist layer PR1.

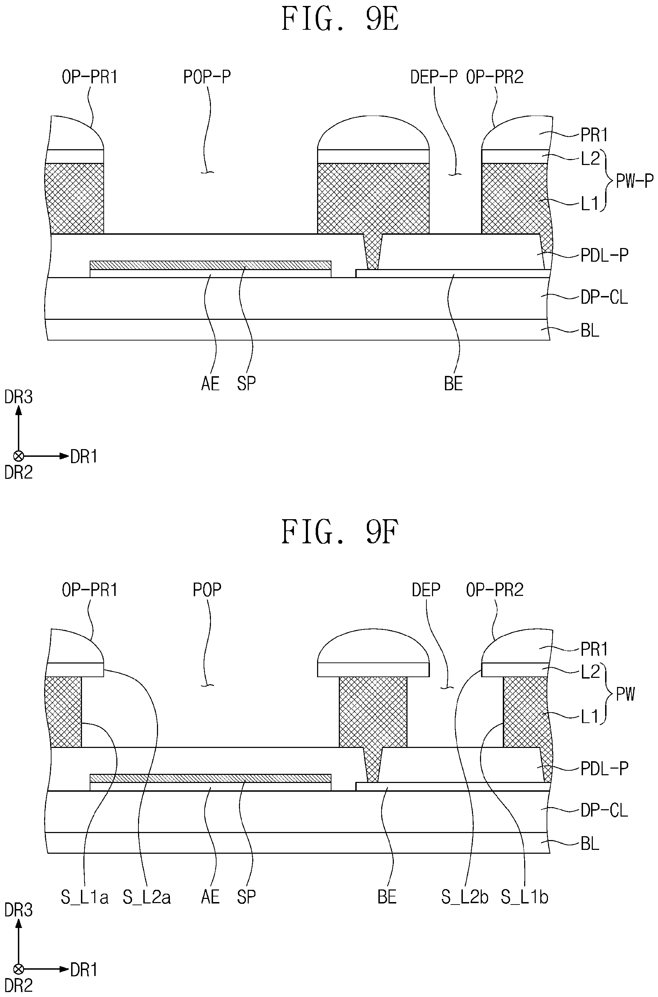

Thereafter, referring to FIGS. 9E and 9F, an operation of forming a pixel opening (or an opening) POP overlapping the anode AE in a plan view on the preliminary partition wall PW-P and the recessed part DEP spaced apart from the pixel opening POP in the first direction DR1 may be performed. The operation of forming the pixel opening POP and the recessed part DEP may include an operation of patterning the preliminary partition wall PW-P. That is, the first photoresist layer PR1 may be used as a mask, the preliminary partition wall PW-P that does not overlap the first photoresist layer PR1 in a plan view may be primarily etched, and thus a preliminary pixel opening POP-P and a preliminary recessed part DEP-P may be formed. The first etching operation may be performed by a dry etching process. A side surface of the preliminary partition wall PW-P that defines the preliminary pixel opening POP-P and the preliminary recessed part DEP-P may be formed perpendicular to the third direction DR3.

Thereafter, the preliminary pixel opening POP-P and the preliminary recessed part DEP-P may be secondarily etched. The second etching operation may be performed in an environment in which etch selectivity between the first partition wall layer L1 and the second partition wall layer L2 is high. In detail, the first photoresist layer PR1 is used as a mask, an operation of patterning the side surface of the preliminary partition wall PW-P that defines the preliminary pixel opening POP-P and the preliminary recessed part DEP-P is performed, and thus the partition wall PW may be formed.

As an etch rate of the first partition wall layer L1 with respect to an etching solution is greater than an etch rate of the second partition wall layer L2 with respect to the etching solution, the first partition wall layer L1 may be mainly etched. Accordingly, the first partition wall layer L1 and the second partition wall layer L2 may include a first side surface S_L1a and a second side surface S_L2a that define a pixel opening POP. Further, the first partition wall layer L1 and the second partition wall layer L2 may include a first side surface S_L1b and a second side surface S_L2b that define the recessed part DEP. The first side surface S_L1a that defines the pixel opening POP may be further recessed inward than the second side surface S_L2a in a plan view, and the first side surface S_L1b that defines the recessed part DEP may be further recessed inward than the second side surface S_L2b in a plan view.

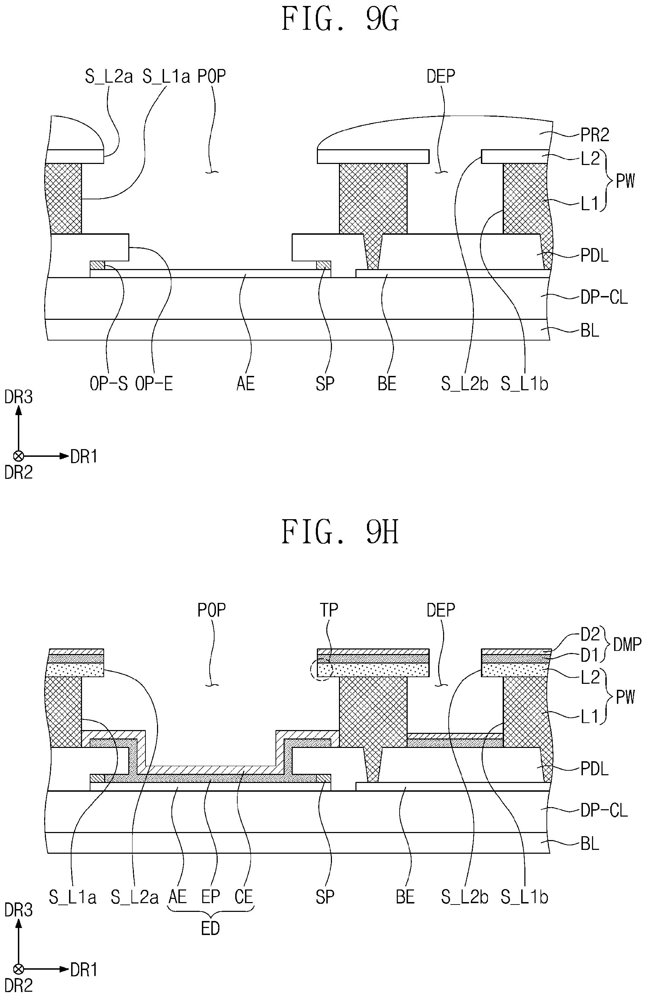

Referring to FIG. 9G, an operation of etching the preliminary pixel defining film PDL-P to form the pixel defining film PDL may be performed. The process of etching the preliminary pixel defining film PDL-P may be performed using a dry etching method and may be performed using a second photoresist layer PR2 as a mask. The light emitting opening OP-E may be formed in the pixel defining film PDL. Thereafter, an operation of etching the sacrificial pattern SP may be performed. The process of etching the sacrificial pattern SP may be performed using a dry etching method and may be performed using the second photoresist layer PR2 as a mask.

The sacrificial opening OP-S corresponding to the light emitting opening OP-E may be formed in the sacrificial pattern SP. At least a portion of the anode AE may be exposed from the sacrificial pattern SP and the pixel defining film PDL through the sacrificial opening OP-S and the light emitting opening OP-E.

The process of etching the sacrificial pattern SP may be performed in an environment in which etch selectivity between the sacrificial pattern SP and the anode AE is high, and therefore, the anode AE may be prevented from being etched together. That is, the sacrificial pattern SP having an etch rate that is greater than an etch rate of the anode AE is disposed between the pixel defining film PDL and the anode AE, and thus the anode AE may be prevented from being etched and damaged together during the etching process.

Thereafter, referring to FIG. 9H, an operation of forming the light emitting pattern EP and an operation of forming the cathode CE may be performed after the second photoresist layer PR2 (see FIG. 9G) is removed.

The operation of forming the light emitting pattern EP and the operation of forming the cathode CE may be performed through a deposition process. In an embodiment, the operation of forming the light emitting pattern EP may be performed through a thermal evaporation process, and the operation of forming the cathode CE may be performed through a sputtering process.

In the operation of forming the light emitting pattern EP, the light emitting pattern EP may be separated by a tip portion TP formed in the first side surface S_L1a and the second side surface S_L2a defining the pixel opening POP and may be disposed inside the light emitting opening OP-E. In the operation of forming the light emitting pattern EP, the first dummy layer D1 that is spaced apart from the light emitting pattern EP may be together formed on the second partition wall layer L2. Further, the first dummy layer D1 may be formed inside the recessed part DEP.

In the operation of forming the cathode CE, the cathode CE may be separated by the tip portion TP formed in the first side surface S_L1a and the second side surface S_L2a defining the pixel opening POP and may be disposed inside the light emitting opening OP-E. The cathode CE may be provided at a high input angle as compared to the light emitting pattern EP, and thus the cathode CE may be formed in contact with the first side surface S_L1a of the first partition wall layer L1. In the operation of forming the cathode CE, the second dummy layer D2 that is spaced apart from the cathode CE may be together formed on the second partition wall layer L2. The second dummy layer D2 may be disposed on the first dummy layer D1. Further, the second dummy layer D2 may be also formed inside the recessed part DEP. The anode AE, the light emitting pattern EP, and the cathode CE may constitute the light emitting element ED.

Thereafter, although not illustrated, an operation of forming a capping pattern on the cathode CE may be added. In this case, similar to the cathode CE, the capping pattern may be separated by the tip portion TP and formed as a dummy pattern on the second partition wall layer L2.

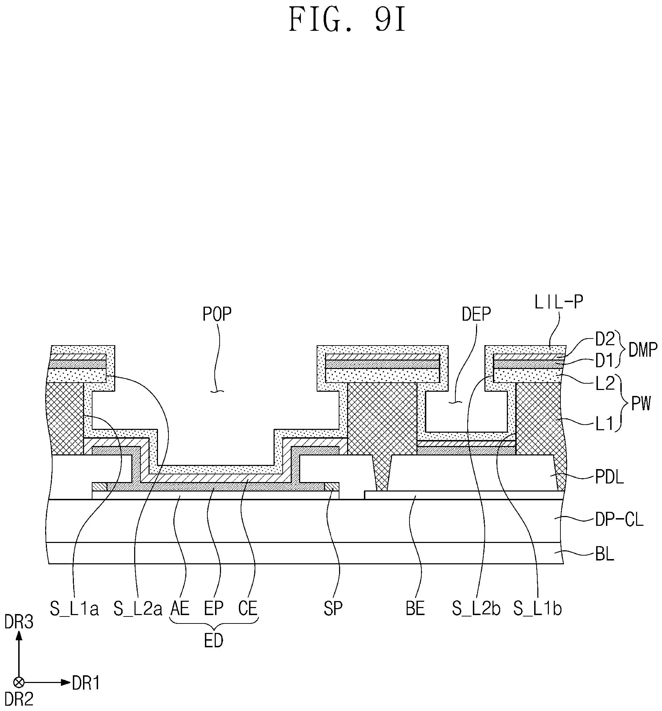

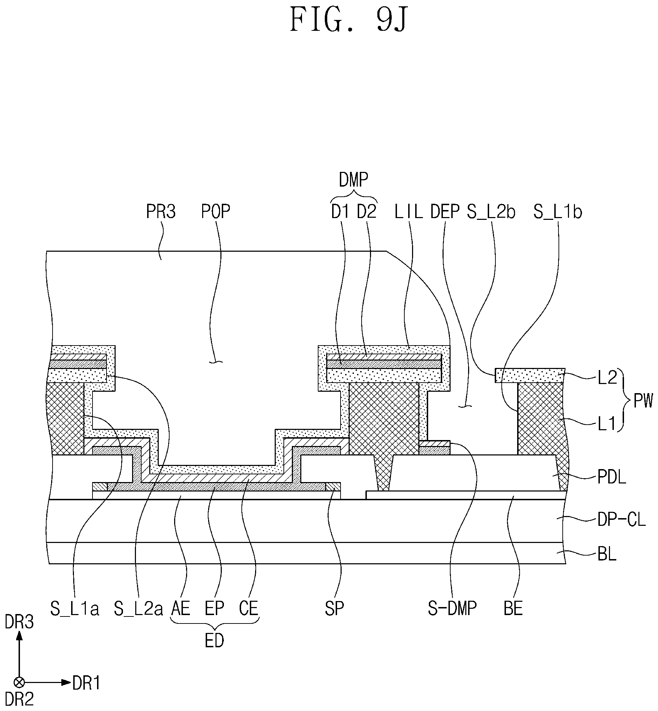

Referring to FIGS. 9I and 9J, the step of forming the lower inorganic pattern LIL may be performed.

Referring to FIG. 9I, an inorganic layer LIL-P may be formed to cover the light emitting element ED and the partition wall PW. The inorganic layer LIL-P may be formed through a deposition process. In an embodiment, the inorganic layer LIL-P may include an inorganic material, for example, silicon nitride (SiNₓ). For example, the inorganic layer LIL-P may be formed through the CVD process.

The inorganic layer LIL-P may cover the light emitting element ED. The inorganic layer LIL-P may be disposed in the recessed part DEP other than the light emitting element ED. In detail, the inorganic layer LIL-P may cover the first side surface S_L1a and the second side surface S_L2a, which define the pixel opening POP, in the pixel opening POP, and may cover the first side surface S_L1b and the second side surface S_L2b, which define the recessed part DEP, in the recessed part DEP.

Thereafter, referring to FIG. 9J, an operation of forming a third photoresist layer PR3 and an operation of forming the lower inorganic pattern LIL may be performed. In the operation of forming the third photoresist layer PR3, the third photoresist layer PR3 may be formed by forming a preliminary photoresist layer, and then patterning the preliminary photoresist layer using a photo mask. Through the patterning process, the third photoresist layer PR3 may be formed in a pattern shape that does not overlap the recessed part DEP in a plan view.

The operation of forming the lower inorganic pattern LIL may include an operation of patterning the inorganic layer LIL-P. In the operation of patterning the inorganic layer LIL-P, the inorganic layer LIL-P may be patterned through dry etching so that a portion of the inorganic layer LIL-P, which overlaps the recessed part DEP in a plan view, is removed. A portion of the lower inorganic pattern LIL may be disposed inside the pixel opening POP and cover the light emitting element ED, and the other portion of the lower inorganic pattern LIL may be formed to cover portions of the first side surface S_L1b and the second side surface S_L2b that define the recessed part DEP. After the operation of forming the lower inorganic pattern LIL, a sub-dummy pattern S-DMP may remain in the recessed part DEP. In the operation of forming the lower inorganic pattern LIL, the third photoresist layer PR3 is formed and patterned on a portion that does not overlap the recessed part DEP spaced apart from the light emitting element ED, i.e., the first partition wall layer L1 in a plan view, and thus the light emitting element ED may be prevented from being damaged in the process.

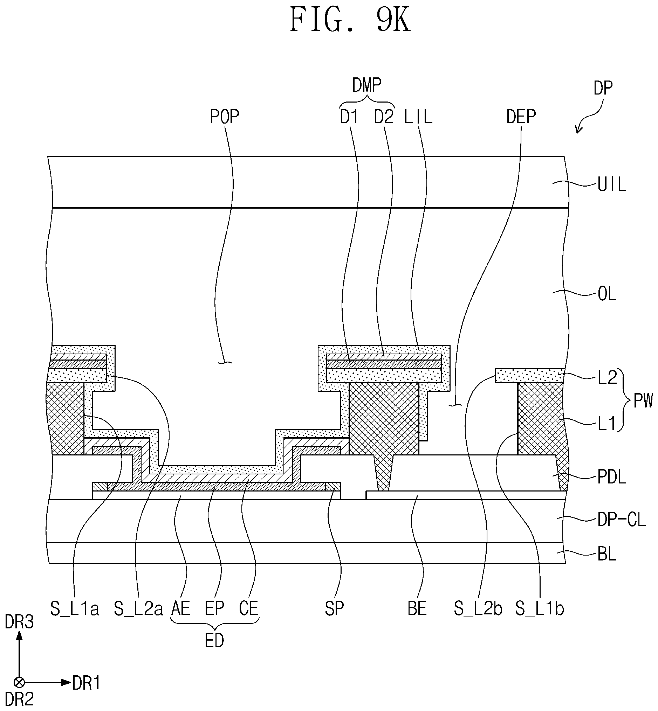

Thereafter, referring to FIG. 9K, the method may include an operation of removing the sub-dummy pattern S-DMP, then forming the organic film OL and the upper inorganic film UIL, and thus completing the display panel DP. The organic film OL may be formed by applying an organic material in an inkjet method, but the present disclosure is not limited thereto. The organic film OL provides a flattened upper surface. Thereafter, the upper inorganic film UIL may be formed by depositing an inorganic material. Therefore, the display panel DP including the base layer BL, the circuit element layer DP-CL, the display element layer DP-OLED, and the encapsulation Layer TFE may be formed.

According to the present disclosure, a display panel having improved process reliability and easy implementation of a high resolution may be provided because a patterned light emitting pattern may be provided without a metal mask.

A partition wall included in the display panel according to the present disclosure includes a recessed part. As an inorganic pattern that covers a light emitting element is formed to cover one side surface of the partition wall that defines the recessed part, a moisture permeation path to the light emitting element may increase. As a result, the light emitting element having improved process reliability and reduced defects by preventing moisture from penetrating into the light emitting element may be provided.

Although the description has been made above with reference to an embodiment of the present disclosure, it may be understood that those skilled in the art or those having ordinary knowledge in the art may variously modify and change the present disclosure without departing from the technical scope of the present disclosure described in the appended claims.

Thus, the technical scope of the present disclosure is not limited to the detailed description of the specification, but should be defined by the appended claims.

## Claims

1. A display panel comprising:
a base layer;
a plurality of light emitting elements arranged on the base layer;
a partition wall disposed between the light emitting elements and configured to electrically connect electrodes of the light emitting elements; and
a plurality of inorganic patterns arranged on the light emitting elements,
wherein a recessed part recessed in a direction to the base layer is defined in the partition wall, and
each of the plurality of inorganic patterns is disposed on the partition wall and covers a first side surface of the partition wall that defines the recessed part.

2. The display panel of claim 1, wherein the partition wall includes a first sub-partition wall and a second sub-partition wall spaced apart from each other with the recessed part therebetween.

3. The display panel of claim 2, further comprising:
a dummy pattern disposed between the partition wall and the inorganic patterns.

4. The display panel of claim 3, wherein the dummy pattern includes:
a first dummy pattern disposed on the first sub-partition wall; and
a second dummy pattern disposed on the second sub-partition wall.

5. The display panel of claim 3 or claim 4, wherein the recessed part includes a first recessed portion and a second recessed portion spaced apart from each other.

6. The display panel of claim 5, wherein the partition wall further includes a third sub-partition wall disposed between the first recessed portion and the second recessed portion, optionally wherein the dummy pattern is not disposed on the third sub-partition wall.

7. The display panel of any one of claims 2 to 6, further comprising:
a bridge electrode configured to electrically connect the first sub-partition wall and the second sub-partition wall.

8. The display panel of claim 7, wherein the light emitting elements further include a first electrode disposed on the base layer, and
the bridge electrode and the first electrode are disposed on a same layer, optionally further comprising:
a pixel defining film, in which a light emitting opening is defined, and which is disposed on the base layer,
wherein a portion of the first electrode is exposed through the light emitting opening,
wherein a first contact hole configured to electrically connect the first sub-partition wall and the bridge electrode and a second contact hole configured to electrically connect the second sub-partition wall and the bridge electrode are defined in the pixel defining film.

9. The display panel of any one of claims 1 to 7, wherein each of the light emitting elements includes:
a first electrode disposed on the base layer;
a light emitting layer disposed on the first electrode; and
a second electrode disposed on the light emitting layer;
wherein the display panel further comprises:
a pixel defining film, in which a light emitting opening is defined and which is disposed on the base layer,
wherein a portion of the first electrode is exposed through the light emitting opening; and
wherein the second electrode is the electrode electrically connected to the partition wall.

10. The display panel of claim 9, wherein the partition wall includes:
a first partition wall layer disposed on the pixel defining film; and
a second partition wall layer disposed on the first partition wall layer, and
a second side surface of the first partition wall layer near the light emitting opening is further recessed in a direction away from the light emitting opening as than a third side surface of the second partition wall layer near the light emitting opening, optionally wherein the second electrode is in direct contact with the first partition wall layer.

11. The display panel of any one of claims 1 to 6, wherein a depth of the recessed part is smaller than a thickness of the partition wall.

12. The display panel of any one of claims 1 to 11, wherein an open area, through which a portion of the first side surface of the partition wall is exposed, is defined between a bottom surface of the recessed part and the inorganic patterns.

13. A method of manufacturing a display panel, the method comprising:
providing a preliminary display panel including a base layer, a first electrode disposed on the base layer, and a preliminary pixel defining film disposed on the base layer and configured to cover the first electrode;
forming a preliminary partition wall on the preliminary pixel defining film;
patterning the preliminary partition wall to form a partition wall in which a recessed part recessed in a direction to the base layer is defined, and which has conductivity;
forming a light emitting layer on the first electrode;
forming a second electrode, which is electrically connected to the partition wall on the light emitting layer; and
forming an inorganic pattern on the second electrode and portions of and the partition wall,
wherein the inorganic pattern is disposed on the partition wall and covers one side surface of the partition wall that defines the recessed part.

14. The method of claim 13, wherein the partition wall includes a first sub-partition wall and a second sub-partition wall spaced apart from each other with the recessed part therebetween,
the preliminary display panel further includes a bridge electrode disposed on the base layer and configured to electrically connect the first sub-partition wall and the second sub-partition wall, and
the bridge electrode is formed in a same process as a process forming the first electrode, optionally further comprising:
forming a contact hole configured to electrically connect the preliminary partition wall and the bridge electrode in the preliminary pixel defining film before the forming of the preliminary partition wall.

15. The method of claim 13 or claim 14, wherein:
(i) the forming of the inorganic pattern includes:
forming an inorganic layer on the second electrode and the partition wall; and
forming the inorganic pattern by patterning the inorganic layer such that the inorganic layer does not overlap at least a portion of the recessed part; and/or
(ii) the method further comprises:
forming an opening overlapping the first electrode in the preliminary partition wall,
wherein the opening and the recessed part are formed simultaneously.
